# EUROPÄISCHE PATENTSCHRIFT

(11) **EP 0 502 148 B1**
(45) Veröffentlichungstag und Bekanntmachung des Hinweises auf die Patenterteilung: **24.05.1995**
(21) Anmeldenummer: 91915927.7
(22) Anmeldetag: 09.09.1991
(51) Int. Cl.: H01L 31/18, H01L 21/363

(54) **VERFAHREN ZUR HERSTELLUNG EINER ABSORBERSCHICHT FÜR SOLARZELLEN MIT HILFE GALVANISCHER ABSCHEIDETECHNIK**
PROCESS FOR PRODUCING AN ABSORBER LAYER FOR SOLAR CELLS, USING ELECTRO-DEPOSITION TECHNIQUE
PROCEDE DE PRODUCTION D'UNE COUCHE D'ABSORPTION POUR CELLULES SOLAIRES PAR UNE TECHNIQUE DE DEPOSITION ELECTROLYTIQUE

(30) Priorität: 22.09.1990 DE 4030057; 04.02.1991 DE 4103291
(43) Veröffentlichungstag der Anmeldung: 09.09.1992
(73) Patentinhaber: YAZAKI CORPORATION, Minato-ku Tokyo 108 (JP)
(72) Erfinder: BONNET, Dieter, D-6281 Friedrichsdorf (DE); EHRHARDT, Josef, D-6203 Hochheim/Main (DE); HEWIG, Gert, D-8755 Alzenau (DE)
(74) Vertreter: Dousse, Blasco (CH)
(86) Internationale Anmeldenummer: EP9101708
(87) Internationale Veröffentlichungsnummer: WO9205586

(56) Entgegenhaltungen:
- EP-A- 0 206 585
- EP-A- 0 297 799
- EP-A- 0 318 315
- EP-A- 0 360 403

## Beschreibung

Die Erfindung betrifft ein Verfahren zur Herstellung einer Absorberschicht für Solarzellen, insbesondere einer CuInSe₂-Absorberschicht, mit Hilfe galvanischer Abscheidetechnik, wobei auf einem elektrisch leitenden Substrat eine Halbleiter-Ternärschicht abgeschieden wird, die aus Elementen der ersten und der dritten Nebengruppe sowie der sechsten Hauptgruppe des periodischen Systems der Elemente besteht.

Eine CuInSe₂-Dünschicht-Solarzelle besteht typischerweise aus einem Substrat, das der Zelle die notwendige Stabilität verleiht. Das Substrat ist mit der erwähnten Absorberschicht beschichtet, die in der Literatur auch als Absorber-Generator bezeichnet wird. Üblicherweise befindet sich zwischen dem Substrat und der Absorberschicht ein großflächiger, metallischer Stromabnahmekontakt. Auf der Oberseite der Absorberschicht befindet sich der Kollektor, mit dessen Hilfe der pn-Übergang erzeugt wird. Beim Beispiel der CuInSe₂-Absorberschicht besteht der Kollektor aus einer Beschichtung aus CdS. Auf der Oberseite des Kollektors ist üblicherweise ein mehr oder weniger feines Gitter aufgebracht, das den Serienwiderstand verringert. Vorstehendes zum allgemeinen Aufbau einer Dünnschicht-Solarzelle wie sie mit Hilfe der nach dem erfindungsgemäßen Verfahren hergestellten Absorberschicht aufgebaut wird.

Für die Herstellung derartiger Absorberschichten gibt es mehrere aufwendige, meist physikalische Verfahren und unter diesen Verfahren verspricht die Herstellung mit Hilfe galvanischer Abscheidetechnik besonders wirtschaftlich und umweltfreundlich zu sein. Mit dieser Technik befaßt sich daher die vorliegende Erfindung.

Am erfolgversprechendsten erscheint gegenwärtig eine Solarzelle, deren Absorberschicht aus CuInSe₂ besteht. Die galvanische Herstellung dieser Absorberschicht ist aber bisher gescheitert, zwar konnten aus saurem Cu-Chlorid, In-Chlorid und Se-Oxid-Bädern Schichten der Zusammensetzung CuInSe₂ abgeschieden werden. Solche Ternär-Bäder sind jedoch instabil und kommen daher für eine wirtschaftliche Fertigung nicht in Betracht.

Zum Stand der Technik wird verwiesen auf
R.N. Bharracharya, Solar Cells, 16 (1986) 237-243,
G. Hodes: Solar Cells, 16 (1986) 245-254,
C.D. Lokhande: I.Electrochem. Soc.,134 (1987) 1727-1729.

Von diesem Stand der Technik geht die Erfindung aus.

Ihr liegt die Aufgabe zugrunde, ein Verfahren zur Herstellung einer Absorberschicht für Solarzellen mit Hilfe der erfolgversprechenden galvanischen Dispersionsabscheidung vorzuschlagen, die wirtschaftlich durchgeführt werden kann. Insbesondere sollen keine Instabilitäten bei den zum Einsatz kommenden galvanischen Bädern auftreten.

Die Lösung dieser Aufgabe gelingt gemäß der im Anspruch 1 definierten Erfindung dadurch, daß auf dem Substrat galvanisch eine binäre Legierung aus Ionen der Elemente der ersten und der dritten Nebengruppe des periodensystems abgeschieden wird sowie gleichzeitig der in dem galvanischen Bad suspendierte Legierungsbestandteil der sechsten Hauptgruppe des periodensystems, der durch Dispersionselektrolyse feindispers in die Legierung eingebaut wird.

Die Erfindung macht sich somit die Erkenntnis zunutze, daß binäre CuIn-Schichten elektrolytisch gut abgeschieden werden können. Der Einbau des Selens - bzw. allgemein des betreffenden Elements der sechten Hauptgruppe des Periodensystems der Elemente - erfolgt erfindungsgemäß durch Dispersionselektrolyse, wodurch die Nachteile beim Stand der Technik vermieden werden, insbesondere geht man nicht mehr den Weg des Abscheidens aus einem Ternärbad, was, wie gesagt, instabil ist.

Die erfindungsgemäße Verfahrensführung behält die Vorteile der Ein-Schritt-Abscheidung auf galvanischem Wege bei, insbesondere die hohe Materialausnutzung mit großem Durchsatz aufgrund der Möglichkeit einer parallelen Beschichtung mehrerer Substrate bzw. der kontinuierlichen Beschichtung des Substrats. Außerdem können die Absorberschichten ohne nachgeschaltete, umweltbelastende Selenidisierung auf einem beliebigen Metallsubstrat abgeschieden werden.

Es sei erwähnt, daß Cu und In vorstehend und nachfolgend als Beispiele für die Elemente der ersten und der dritten Nebengruppe des periodensystems der Elemente erwähnt werden und Selen als Beispiel für ein Element der sechsten Hauptgruppe des Periodensystems. Grundsätzlich kommen aber alle anderen Elemente dieser Nebengruppen bzw. der erwähnten Hauptgruppe für das erfindungsgemäße Verfahren infrage.

Erfindungsgemäß wird somit z.B. eine binäre CuIn-Legierung galvanisch auf einem Metallsubstrat abgeschieden. Gleichzeitig werden aufgrund des Prinzips der Dispersionselektrolyse feine, im Elektrolyt suspendierte Se-Partikel in die sich bildende CuIn-Schicht feindispers eingelagert, so daß nach einer thermisch-chemischen Reaktion der Komponenten als Endprodukt eine ternäre CuInSe₂-Legierung resultiert, d.h. die gewünschte Absorberschicht.

Ausgestaltungen der Erfindung sind in den Unteransprüchen enthalten.

Bei Ausführung des Verfahrens in Form einer Bandgalvanisierung bietet sich die kontinuierliche Herstellung von Absorberschichten in technischem Maßstab an. Der Se-Einbau kann sowohl an vertikal als auch an horizontal angeordneten Kathodenwerkstoffen erfolgen. Ein sehr hoher Se-Einbau kann bei horizontaler Kathode durch Ausnutzung des Sedimentationseffekts erreicht werden. Zur Erhöhung des Se-Einbaus in die binäre Legierung können die Se-Partikel auch durch schwere einwertige Metallionen (z.B. Cäsium-Ionen) oder durch oberflächenaktive Substanzen konditioniert werden. Ebenso können zur Erzielung einer optimalen Schichtzusammensetzung bei der Abscheidung die Möglichkeiten der Ultraschallanwendung des Jet-Plating und/oder des Pulse-Plating herangezogen werden.

Zur Erzeugung einer für die photovoltaische Energieumwandlung optimalen Kristallstruktur und Oberflächenmorphologie kann die beispielhaft angeführte CuInSe₂-Dispersionsschicht einer Diffusions- bzw. Kristallisations-Wärmebehandlung unterzogen werden. Die erfindungsgemäß eingesetzten Se-Pulver können durch Mahlen und Klassieren kommerzieller Pulver auf die erforderliche Feinheit gebracht werden, sie können ebenso durch Reduktion seleniger Säure mit Schwefeldioxid hergestellt und durch Wärmebehandlung in die für Halbleiter erforderliche hexagonal kristallisierte Form gebracht werden.

Mit dem Verfahren gemäß der Erfindung können somit durch Dispersionselektrolyse auf einfache und umweltschonende Weise Absorberschichten in technischem Maßstab hergestellt werden.

Weil die Schichtdicke der Absorberschicht üblicherweise einige »m beträgt, muß beispielsweise ein sehr feines Selenpulver verwendet werden. Neben den üblichen Verfahrensmaßnahmen des Mahlens mit anschließendem Klassieren kann dieses auch mit Hilfe der Verfahrensschritte nach Patentanspruch 10 hergestellt werden, wodurch sich ebenfalls ein Pulver mit einer Korngröße in der Größenordnung kleiner als 1»m herstellen läßt.

Durch die Maßnahmen von Patentanspruch 11 wird das Se-Pulver in die für die Herstellung von Solarzellen besonders vorteilhafte hexagonale Kristallform gebracht.

Durch die Maßnahmen von Patentanspruch 12 werden die photovoltaischen Eigenschaften der Absorbtionsschicht verbessert.

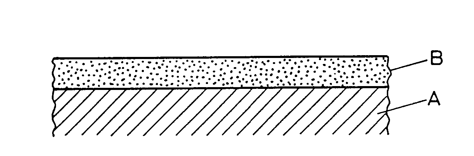

Bild 1 zeigt schematisch eine durch Dispersionselektrolyse auf einem elektrisch leitfähigem Substrat (A) abgeschiedene Kupfer-Indium-Selen-Dispersionsschicht (B).

Im folgenden ist ein Ausführungsbeispiel für das erfindungsgemäße Verfahren aufgeführt.
Aus einem galvanischen Bad auf Sulfamatbasis mit 0,5 mol/l Cu und 0,01 mol/l In, in dem 50 g/l Se-Pulver suspendiert waren, wurde bei einer Stromdichte von 3 A/dm² eine 10 »m dicke, zusammenhängende und auf dem Substrat gut haftende CuInSe-Schicht folgender Zusammensetzung abgeschieden:
Cu = 20,5 Gew.%; In = 44,1 Gew.%; und Se = 35,4 Gew.%.

Die in diesem Beispiel verwendeten In- und Se-Gehalte der Abscheidung sind ohne weiteres variierbar, z.B. in der Weise, daß der Se-Gehalt erhöht und der In-Gehalt erniedrigt wird. Statt der Sulfamatbasis sind auch andere Badtypen z.B. auf der Basis Chlorid, Cyanit und Sulfat möglich.

## Patentansprüche

1. Verfahren zur Herstellung einer Absorberschicht für Solarzellen, insbesondere einer CuInSe₂-Absorberschicht, mit Hilfe galvanischer Abscheidetechnik, wobei auf einem elektrisch leitenden Substrat eine Halbleiter-Ternärschicht abgeschieden wird, die aus Elementen der ersten und der dritten Nebengruppe sowie der sechsten Hauptgruppe des periodischen Systems der Elemente besteht,
**dadurch gekennzeichnet**,
daß auf dem Substrat galvanisch eine binäre Legierung aus Ionen der Elemente der ersten und der dritten Nebengruppe des Periodensystems abgeschieden und gleichzeitig der in dem galvanischen Bad suspendierte Legierungsbestandteil der sechsten Hauptgruppe des Periodensystems, durch Dispersionselektrolyse feindispers in die Legierung eingebaut wird, die dann durch thermische Nachbehandlung in eine Verbindung des Typs I-III-VI₂ umgewandelt wird.

2. Verfahren nach Anspruch 1,
**dadurch gekennzeichnet**,
daß, bezogen auf die binäre Legierung, der Volumenanteil der beiden Komponenten der binären Legierung jeweils zwischen 25 bis 75% beträgt.

3. Verfahren nach Anspruch 1 oder 2,
**dadurch gekennzeichnet**,
daß, bezogen auf die Ternärschicht, der Volumenanteil des durch die Dispersionselektrolyse in die binäre Legierung eingebauten Legierungsbestandteile 25 bis 70% beträgt.

4. Verfahren nach einem der Ansprüche 1 bis 3,
**dadurch gekennzeichnet,**
daß die Dispersionselektrolyse unter Einsatz von Pulse-Plating, Jet-Plating und/oder Ultraschall erfolgt.

5. Verfahren nach einem der Ansprüche 1 bis 4,
**dadurch gekennzeichnet**,
daß die Abscheidung des in dem galvanischen Bad suspendierten Legierungsbestandteils durch Sedimentation unterstützt wird.

6. Verfahren nach einem der Ansprüche 1 bis 5,
**dadurch gekennzeichnet**,
daß die Abscheidung nach Art der Bandgalvanisierung kontinuierlich erfolgt.

7. Verfahren nach einem der Ansprüche 1 bis 6,
**dadurch gekennzeichnet**,
daß die Konzentration des einzulagernden, im Elektrolyt suspendierten Elements 10 bis 500 g/l beträgt.

8. Verfahren nach einem der Ansprüche 1 bis 7,
**dadurch gekennzeichnet**,
daß das einzulagernde Elementpulver mit oberflächenaktiven Substanzen konditioniert wird.

9. Verfahren nach einem der Ansprüche 1 bis 8,
**dadurch gekennzeichnet**,
daß das einzulagernde Elementpulver durch Mahlen und Klassieren hergestellt wird.

10. Verfahren nach einem der Ansprüche 1 bis 8,
**dadurch gekennzeichnet**,
daß bei Verwendung von Se als einzulagerndes Elementpulver dieses durch Reduktion von seleniger Säure mit Schwefeldioxid hergestellt wird.

11. Verfahren nach einem der Ansprüche 1 bis 10,
**dadurch gekennzeichnet**,
daß bei Verwendung von Se als einzulagerndes Elementpulver dieses durch eine Wärmebehandlung in eine halbleitende hexagonale Kristallform gebracht worden ist.

12. Verfahren nach einem der Ansprüche 1 bis 11,
**dadurch gekennzeichnet**,
daß die Beschichtung des Substrats einer Diffusionserwärmung unterworfen wird.

## Claims

1. A process for the production of an absorber layer for solar cells, in particular a CuInSe₂ absorber layer, using an electrodeposition technique, wherein a semi-conducting ternary layer is deposited on an electrically conducting substrate and comprises elements of the first and the third subgroup and also the sixth main group of the periodic system of elements, characterised in that a binary alloy of ions of the elements of the first and the third subgroup of the periodic system is electrodeposited on the substrate and the alloying constituent of the sixth main group of the periodic system, being suspended in the electroplating bath, is simultaneously incorporated into the alloy in a finely dispersed manner by dispersion electrolysis, the alloy then being converted by thermal aftertreatment into a compound of the I-III-VI₂ type.

2. A process according to claim 1, characterised in that, with respect to the binary alloy, the percentage by volume of each of the two constituents of the binary alloy is between 25% and 75%.

3. A process according to claim 1 or 2, characterised in that, with respect to the ternary layer, the percentage by volume of the alloying constituent incorporated into the binary alloy by dispersion electrolysis is 25% to 70%.

4. A process according to any one of claims 1 to 3, characterised in that dispersion electrolysis is carried out by means of pulse-plating, jet-plating and/or using ultrasound.

5. A process according to any one of claims 1 to 4, characterised in that the deposition of the alloying constituent suspended in the electroplating bath is assisted by sedimentation.

6. A process according to any one of claims 1 to 5, characterised in that deposition is carried out continuously in the manner of conveyor electroplating.

7. A process according to any one of claims 1 to 6, characterised in that the concentration of the element for dispersion suspended in the electrolyte is 10 to 500 g/l.

8. A process according to any one of claims 1 to 7, characterised in that the powdered element to be dispersed is conditioned with surface-active substances.

9. A process according to any one of claims 1 to 8, characterised in that the powdered element to be dispersed is prepared by grinding and grading.

10. A process according to any one of claims 1 to 8, characterised in that, when using Se as the powdered element to be dispersed, it is prepared by reducing selenious acid with sulphur dioxide.

11. A process according to any one of claims 1 to 10, characterised in that, when using Se as the powdered element to be dispersed, it has been given a semi-conducting, hexagonal crystalline form by heat treatment.

12. A process according to any one of claims 1 to 11, characterised in that the coating of the substrate is subjected to diffusion heating.

## Revendications

1. Procédé de préparation d'une couche absorbante pour cellules solaires, en particulier d'une couche absorbante en CuInSe₂, à l'aide d'une technique de dépôt galvanique, dans laquelle on dépose une couche ternaire semi-conductrice sur un substrat conducteur de l'électricité, couche qui est constituée d'éléments des premier et troisième sous-groupes ainsi que du sixième groupe principal du système périodique des éléments, caractérisé en ce qu'on dépose simultanément, par voie galvanique, un alliage binaire formé d'ions des éléments des premier et troisième sous-groupes du système périodique des éléments, et simultanément la partie de l'alliage correspondant au sixième groupe principal du système périodique des éléments, par électrolyse en dispersion, à partir d'une suspension de cet élément dans le bain galvanique de façon à l'incorporer dans l'alliage sous une forme finement dispersée, l'alliage étant ensuite transformé en un composé de type I-III-VI₂ par un post-traitement thermique.

2. Procédé selon la revendication 1, caractérisé en ce que, par rapport à l'alliage binaire, la proportion volumique des deux composants de l'alliage binaire est de l'ordre, respectivement, de 25 % à 75 %.

3. Procédé selon les revendications 1 ou 2, caractérisé en ce que, rapportée à la couche ternaire, la proportion volumique des composants de l'alliage incorporés dans l'alliage binaire par électrolyse en dispersion est de l'ordre de 25 % à 70 %.

4. Procédé selon l'une des revendications 1 à 3, caractérisé en ce que l'électrolyse en dispersion s'effectue par la mise en oeuvre de Pulse-Plating, Jet-Plating et/ou d'ultrasons.

5. Procédé selon l'une des revendications 1 à 4, caractérisé en ce que le dépôt de la composante de l'alliage dispersée dans le bain galvanique est favorisé par sédimentation.

6. Procédé selon l'une des revendications 1 à 5, caractérisé en ce que le dépôt s'effectue en continu selon la méthode de la galvanisation de tôles en ruban.

7. Procédé selon l'une des revendications 1 à 6, caractérisé en ce que la concentration de l'élément devant être incorporé, en suspension dans l'électrolyte, est de 10 à 500 g/l.

8. Procédé selon l'une des revendications 1 à 7, caractérisé en ce que l'élément pulvérulent devant être incorporé est conditionné grâce à des substances tensio-actives.

9. Procédé selon l'une des revendications 1 à 8, caractérisé en ce que l'élément pulvérulent devant être incorporé est obtenu par broyage et tamisage.

10. Procédé selon l'une des revendications 1 à 8, caractérisé en ce que, lors de l'utilisation de Se en tant qu'élément pulvérulent d'incorporation, celui-ci est obtenu par réduction d'acide sélénieux avec du dioxyde de soufre.

11. Procédé selon l'une des revendications 1 à 10, caractérisé en ce que, lors de l'utilisation de Se en tant qu'élément pulvérulent d'incorporation, celui-ci est transformé, par traitement thermique, en une forme cristalline hexagonale semi-conductrice.

12. Procédé selon l'une des revendications 1 à 11, caractérisé en ce que le revêtement du substrat est soumis à un traitement de recuit par diffusion.
